Europäisches Patentamt
European Patent Office
Office européen des brevets

(11) **EP 3 152 621 B1**

(12) **EUROPÄISCHE PATENTSCHRIFT**

(45) Veröffentlichungstag und Bekanntmachung des Hinweises auf die Patenterteilung:
**03.04.2019 Patentblatt 2019/14**

(21) Anmeldenummer: **15724727.1**

(22) Anmeldetag: **02.06.2015**

(51) Int Cl.:
*G03F 7/09* (2006.01)   *G03F 7/20* (2006.01)
*G03F 7/26* (2006.01)   *G03F 7/30* (2006.01)
*G03F 7/34* (2006.01)   *G03F 7/40* (2006.01)

(86) Internationale Anmeldenummer:
**PCT/EP2015/062196**

(87) Internationale Veröffentlichungsnummer:
**WO 2015/185523 (10.12.2015 Gazette 2015/49)**

(54) **SCHNELL TROCKENBARE FLEXODRUCKELEMENTE**

FLEXOGRAPHIC PRINTING ELEMENTS THAT AN BE DRIED RAPIDLY

ÉLÉMENTS DE FLEXOGRAPHIE À SÉCHAGE RAPIDE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **03.06.2014 EP 14170874**

(43) Veröffentlichungstag der Anmeldung:
**12.04.2017 Patentblatt 2017/15**

(73) Patentinhaber: **Flint Group Germany GmbH**
**70469 Stuttgart (DE)**

(72) Erfinder:
- BECKER, Armin
  **67259 Grossniedesheim (DE)**

- UNGLAUBE, Jochen
  **79341 Kenzingen (DE)**
- WOCHELE, Andrea
  **71254 Ditzingen (DE)**

(74) Vertreter: **Schuck, Alexander**
**Patentanwälte**
**Isenbruck Bösl Hörschler PartG mbB**
**Eastsite One**
**Seckenheimer Landstraße 4**
**68163 Mannheim (DE)**

(56) Entgegenhaltungen:
**EP-A1- 1 014 194   EP-A2- 1 457 823**
**EP-A2- 1 594 005   EP-A2- 2 284 609**
**WO-A1-94/03838   WO-A1-96/14603**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

EP 3 152 621 B1

**Beschreibung**

Die vorliegende Erfindung betrifft ein Verfahren zur Herstellung von fotopolymerisierbaren, bevorzugt digital bebilderbaren, fotopolymerisierbaren Flexodruckelementen, welche eine PET-Trägerfolie mit einer geringen thermischen Schrumpfung aufweisen, sowie deren Verwendung zur Herstellung von Flexodruckplatten durch bildmäßiges Belichten, Auswaschen mit organischen Lösemitteln und Trocknen, wobei man das Trocknen bei Temperaturen von mehr als 60°C durchführt.

Laserablatierbare Flexodruckelemente sind prinzipiell bekannt. Sie umfassen mindestens einen dimensionsstabilen Träger, eine fotopolymerisierbare Schicht sowie eine laserablatierbare Schicht, auch LAMS (laserablatierbare Maskenschicht) genannt. In der Regel ist die laserablatierbare Schicht durch eine abziehbare Schutzfolie, die sogenannte Deckfolie geschützt. Die fotopolymerisierbare Schicht kann aus wasserlöslichen Komponenten aufgebaut sein, verbreitet sind aber vor allem in organischen Lösemitteln lösliche fotopolymerisierbare Schichten. Derartige Flexodruckelemente werden auch als digital bebilderbare Flexodruckelemente bezeichnet.

Die Herstellung von Flexodruckformen ausgehend von fotopolymerisierbaren, laserablatierbaren Flexodruckelementen erfolgt mittels eines mehrstufigen Prozesses unter Verwendung entsprechender Vorrichtungen für jeden Verfahrensschritt. Es handelt sich um einen komplexen und zeitaufwändigen Prozess.

Zunächst wird die Deckfolie abgezogen und eine Maske in die laserablatierbare Schicht unter Verwendung eines IR-Lasers eingeschrieben. Es kann sich hierbei um Laserapparaturen mit rotierender Trommel, Flachbettapparaturen oder Innentrommellaser handeln.

Nach dem Einschreiben der Maske wird das Flexodruckelement durch die gebildete Maske hindurch mit UV-Strahlung bzw. UV/VIS-Strahlung belichtet. Die fotopolymerisierbare Schicht polymerisiert in den von der Maske nicht mehr abgedeckten Bereichen, während in den abgedeckten Bereichen keine Polymerisation erfolgt. Hierfür werden UV-Belichter verwendet, welche verschiedene UV-Quellen umfassen können, beispielsweise UV-Röhren oder UV-LEDs.

Nach der Belichtung werden die Reste der Maske sowie die nicht polymerisierten Anteile der fotopolymerisierbaren Schicht entfernt. Dies kann unter Verwendung von einem oder mehreren Lösemitteln oder auch thermisch erfolgen. Zum Auswaschen mittels Lösemittel werden spezielle Auswaschgeräte, z.B. Bürstenwascher verwendet. Zum thermischen Entwickeln können Geräte verwendet werden, bei denen ein saugfähiges Vließ mittels einer beheizten Rolle an die belichtete Schicht gedrückt wird.

Im Zuge des Auswaschens mithilfe von organischen Lösemitteln werden die nicht polymerisierten Anteile der reliefbildenden Schicht im Lösemittel gelöst. Als Auswaschmittel werden üblicherweise Gemische verwendet, welche hochsiedende Kohlenwasserstoffe (Siedebereich typischerweise ca. 150°C bis 200°C) enthalten. Die polymerisierten Anteile der Schicht werden nicht gelöst und bilden nach dem Auswaschen das druckende Relief. Sie quellen aber gleichwohl im Auswaschmittel auf. Bei Verwendung von Lösemitteln zum Entwickeln der Platte schließt sich daher ein Trockenschritt in einem Trockner an. Die Trocknung wird üblicherweise in Umlufttrocknern bei einer Temperatur von maximal 60°C durchgeführt.

Üblicherweise wird die Oberfläche der erhaltenen Flexodruckform nach dem Trocknen nachbehandelt, beispielsweise durch Belichten der Oberfläche mit UVA- und/oder UVC-Strahlung. Hierfür werden wiederum entsprechende Belichtungsapparaturen verwendet.

Zeitbestimmender Schritt bei der Herstellung von Flexodruckplatten ist die Trocknung der ausgewaschenen Flexodruckplatten. Belichtung, Auswaschen sowie Nachbehandlung benötigen in der Regel jeweils 10 bis 20 Minuten. Der Trocknungsschritt dauert dagegen je nach verwendetem Plattentyp und insbesondere der Plattendicke mindestens 60 Minuten bis hin zu 3 oder 4 Stunden. Die lange Trocknungszeit - insbesondere bei dicken Flexodruckplatten - wird benötigt, um auch Reste der hochsiedenden Auswaschmittel aus der Flexodruckplatte möglichst quantitativ zu entfernen. Zur Bestimmung der Trocknungszeit wird üblicherweise die Schichtdicke der Flexodruckplatte vor und nach dem Auswaschen gemessen und dann mit der Schichtdicke der Flexodruckplatte nach unterschiedlichen Trocknungszeiten verglichen. Die Trocknung kann auch über die Gewichtsabnahme der Flexodruckplatte während der Trocknung verfolgt werden.

Reste von Auswaschmittel in der Reliefschicht wirken sich nachteilig auf das Druckergebnis aus. Die feinen Raster stehen dann höher als die Vollflächen und die Tonwertzunahme bei niedrigen Tonwerten steigt an. Feine Rasterverläufe können drucktechnisch nicht mehr realisiert werden. Eine ausreichende Trocknungszeit ist daher nicht verzichtbar.

Die Trocknungszeit bestimmt daher maßgeblich die Gesamtherstellungszeit einer Flexodruckplatte. Bei den geschilderten Trockenzeiten können Druckaufträge mittels Flexodruck nicht zeitnah abgewickelt werden, sondern ein Vorlauf von einem Tag ist mindestens notwendig, bevor ein Druckauftrag in einer Druckmaschine realisiert werden kann. Dies ist in Zeiten immer kürzerer Aufträge, oft gesplittet in zahlreiche Wiederholungsaufträge, unwirtschaftlich. Auch kann bei Beschädigung einer Flexodruckplatte kurzfristig kein Ersatz bereitgestellt werden, sondern der Druckauftrag muss abgebrochen werden. Am nächsten Tag müssen alle Flexodruckplatten neu montiert werden bevor der Druckauftrag fertiggestellt werden kann, was wiederum Kosten und Zeit erfordert.

Es hat daher nicht an Versuchen gefehlt, diese nachteilige Eigenschaft von Flexodruckformen zu eliminieren und die Trocknungszeit zu verkürzen.

Selbstredend kann die Trocknungsgeschwindigkeit prinzipiell durch die Erhöhung der Trocknungstemperatur gesteigert werden. Versuche, die Trocknungsgeschwindigkeit handelsüblicher Flexodruckplatten durch Erhöhung der Trocknungstemperatur zu beschleunigen, führten aber zu Problemen mit der Plattenqualität. Die bei höherer Temperatur getrockneten Flexodruckplatten zeigten im Druck Probleme mit unzureichender Registergenauigkeit. Flexodruckplatten müssen eine ausgezeichnete Maßhaltigkeit besitzen, da im Druck mehrere Farben zusammen gedruckt werden. Die Anforderungen an die Registergenauigkeit, d.h. die Genauigkeit, mit der einzelne Bildelemente auf dem Druck zusammenkommen, beträgt etwa 0,1 bis 0,2 mm bei einer Druckbreite von etwa einem Meter. Die Maßhaltigkeit einer Flexodruckplatte muss folglich besser als 0,02 % sein.
Grund für die Registerprobleme von bei höherer Temperatur getrockneten, handelsüblichen Flexodruckplatten ist das thermische Verhalten der Polyesterträgerfolie, auf der die fotopolymerisierbare Schicht der Flexodruckplatte aufgebracht ist. Kommerziell verfügbare Polyesterfolien, die bei der Herstellung von handelsüblichen Flexodruckplatten eingesetzt werden, schrumpfen, wenn sie auf Temperaturen über der Glasübergangstemperatur des Polyesters (ca. 70°C) erhitzt werden. Es ist daher erforderlich, die Trocknungstemperatur auf Temperaturen unterhalb der Glasübergangstemperatur einzustellen, damit es keine Verzüge durch nicht kontrollierbare Schrumpfprozesse gibt.

In der WO 2005/121898 A1 wird ein Verfahren beschrieben, bei dem man die Trocknung von Flexodruckplatten durch zusätzliche Bestrahlung mit sichtbarem Licht beschleunigt. Dieses Verfahren ergab aber keine konsistenten Ergebnisse und konnte sich deshalb im Markt nicht durchsetzen.

Als Alternative zu lösemittelauswaschbaren Platten sind wasserauswaschbare Flexodruckplatten bekannt. Wasserauswaschbare Flexodruckplatten können wegen des niedrigeren Siedepunkts von Wasser im Vergleich zu organischen Auswaschmitteln deutlich schneller getrocknet werden als in organischen Lösungsmitteln ausgewaschene Flexodruckplatten. Allerdings kommt die Qualität und Auflagenbeständigkeit von wasserauswaschbaren Flexodruckplatten nicht an die Qualität von in organischen Lösungsmitteln ausgewaschenen Flexodruckplatten heran.

Als Alternative zu lösemittelauswaschbaren Platten sind weiterhin thermisch entwickelbare Flexodruckplatten bekannt. Hierbei werden die nicht polymerisierten Bereiche zur Schmelzflüssigkeit erhitzt und die Schmelze wird mit einem saugfähigen Material aufgesogen. Eine Trocknung ist bei thermisch entwickelbaren Flexodruckplatten nicht erforderlich. Allerdings erreichen thermische Flexodruckplatten bei weitem nicht die Qualität von in organischen Lösungsmitteln ausgewaschenen Flexodruckplatten.

WO 96/14603 A1 schlägt fotopolymerisierbare Flexodruckelemente für die thermische Entwicklung vor, umfassend einen dimensionsstabilen, flexiblen polymeren Träger sowie eine photopolymerisierbare Elastomerschicht, wobei die Platte eine thermische Verzerrung von weniger als 0,03 % sowohl in transversaler als auch in longitudinaler Richtung aufweist, wenn die Platte nach dem bildmäßigen Belichten bei Temperaturen von 100 bis 180°C entwickelt wird.

Zur Herstellung des Flexodruckelements werden Trägerfolien aus semikristallinen Polymeren verwendet. Es werden eine Vielzahl unterschiedlicher Materialien wie Polyethylennaphthalat (PEN), Polyethylenterephthalat, Polyetherketone, Polytetraflourethylen, Polyamide, syndiotaktisches Polystyrol und Polyphenylensulfid genannt. Die Folien werden vor dem Einsatz getempert.

Die Herstellung der Flexodruckelemente erfolgt gemäß den Beispielen von WO 96/14603 A1, indem man eine PEN-Tägerfolie einer Dicke von 0,178 mm bei 160°C bei einem definierten Zug tempert. Die Substrate werden dann coronabehandlet und mit einem Aziridin-Primer beschichtet. Anschließend wird eine fotopolymerisierbare elastomere Schicht auflaminiert. Zur Herstellung von Flexodruckplatten werden die Flexodruckelemente durch ein Negativ hindurch bildmäßig belichtet und anschließend thermisch entwickelt, wobei die Entwicklungsrolle eine Temperatur von 176°C aufweist. Die Schichtdicke der photopolymerisierbaren Schicht beträgt 0,3 mm bis 3 mm. WO 96/14603 A1 offenbart nicht das Verarbeiten der Flexodruckelemente unter Verwendung von Auswaschmitteln.

"Schrumpflose" Polyesterfolien mit einem geringen thermischen Schrumpf sind prinzipiell bekannt und auch kommerziell erhältlich. Die Herstellung derartiger Folien erfolgt üblicherweise durch Extrusion aus einer Breitschlitzdüse mit anschließender Verstreckung in Maschinen- und quer zur Maschinenrichtung. Diese Verstreckung findet oberhalb der Glastemperatur statt, so dass kommerziell verfügbare PET-Folien meist unterschiedliche Schrumpfwerte in Maschinenrichtung (MD) und quer zur Maschinenrichtung (TD) aufweisen. Um die Folien nun schrumpflos zu machen, werden diese auf die geforderte Temperatur erhitzt und für eine definierte Zeit spannungsfrei gehalten, so dass vorhandene Schrumpfspannungen relaxieren können. Danach wird die PET-Folie abgekühlt und erst nach Unterschreiten der Glastemperatur mit Zug beansprucht. Auf diese Weise hergestellte PET-Folien weisen Schrumpfwerte von weniger als 0,02 % auf.

Allerdings führt der Einsatz einer schrumpflosen Folie bei der Produktion der Flexodruckelemente nach bekannten Verfahren nicht zu Flexodruckplatten mit exzellenter Registergenauigkeit, da die Folien bei der Herstellung der Flexodruckelemente erneut thermisch belastet werden.

Die übliche Herstellung von fotopolymerisierbaren Flexodruckelementen erfolgt in einem Verfahren, bei dem die Komponenten der fotopolymerisierbaren Schicht in einem Extruder gemischt und aufgeschmolzen werden. Anschließend wird die Schmelze in den Spalt eines Kalanders eingeführt, über dessen beheizte Walzen die Deck- und Trägerfolien eingeführt werden. Bei diesem Prozess kommen die PET-Folien mit der heißen fotopolymerisierbaren Schmelze in Kontakt und nehmen die Temperatur der Schmelze an.

Ein weiteres Verfahren zur Herstellung eines fotopolymerisierbaren Flexodruckelements zur Herstellung von Flexodruckplatten, in welchem eine nicht näher spezifizierte PET Trägerfolie verwendet wird, wird in WO 94/03838 A1 beschrieben. Das Herstellungsverfahren umfasst das Bereitstellen eines Deckelements mit einer Deckfolie (eine sogenannte zweite temporäre Deckschicht), die an die fotopolymerisierbare Schicht angrenzt und auch eine IR-empfindliche Schicht oder Sperrschicht tragen kann, das Aufschmelzen und Mischen der Komponenten der fotopolymerisierbaren, reliefbildenden Schicht in einem Extruder, und Kalandrieren der Schicht zwischen Trägerfolie und Deckelement, wobei über eine Walze des Kalanders eine temporäre Trägerfolie und über die andere Walze des Kalanders das Deckelement eingefahren wird, Entfernen der temporären Deckfolie von der fotopolymerisierbaren Schicht, Verbinden mit dem zweiten Element, bestehend aus zweiter, temporärer Trägerfolie, IR-empfindlicher Schicht und Sperrschicht, dergestalt, dass die Sperrschicht und die fotopolymerisierbare Schicht grenzt. Die zweite temporäre Trägerfolie kann an Ort und Stelle verbleiben und kann als Schutz zur Lagerung dienen. Die Schmelze der Komponenten der fotopolymerisierbaren, reliefbildenden Schicht werden nach WO 94/03838 A1 nicht auf eine Deckfolie, sondern direkt auf die Trägerfolie kalandriert.

Die Temperatur der fotopolymerisierbaren Schmelze liegt üblicherweise bei 120°C bis 150°C, also weit über dem Glaspunkt von Polyethylenterephthalat. Des Weiteren muss der entstehende Verbund aus fotopolymerisierbarer Schicht, Deck- und Trägerfolie durch die Anlage transportiert werden. Dabei werden Scherkräfte auf die heißen PET-Folien ausgeübt. Daher haben selbst unter Verwendung schrumpfloser PET-Folien hergestellte Flexodruckplatten nach Durchlaufen dieses Produktionsschrittes wieder Schrumpfwerte, die über der geforderten Maßhaltigkeit von < 0,02 % liegen.

Darüber hinaus ist es schwierig, mit dem oben genannten Verfahren und mit schrumpflosen PET-Folien wellenfreie Flexodruckplatten herzustellen. Da der Zug in Maschinenrichtung höher ist als senkrecht zur Maschinenrichtung, ist es vorteilhaft, wenn die PET-Folien in Maschinenrichtung einen höheren Schrumpf aufweisen als senkrecht dazu. Nur so können Flexodruckelemente wellenfrei produziert werden. Auf solche Art und Weise hergestellte Flexodruckelemente weisen aber stets einen Restschrumpf auf. Dieser verhindert, dass die geforderte Maßhaltigkeit bei Trocknung bei erhöhten Temperaturen erreicht werden kann.

Aufgabe der vorliegenden Erfindung war es deshalb, ein Herstellungsverfahren für fotopolymerisierbare Flexodruckelemente zur Herstellung von Flexodruckplatten durch Belichten, Auswaschen mit organischen Auswaschmitteln und Trocknen bereitzustellen, welche auch bei Temperaturen von mehr als 60°C getrocknet werden können, ohne dass die Registergenauigkeit beeinträchtigt wird.

Dementsprechend wurden fotopolymerisierbare, unter Verwendung von Kohlenwasserstoffe umfassenden Auswaschmitteln entwickelbare Flexodruckelemente zur Herstellung von Flexodruckplatten gefunden, umfassend - in der genannten Reihenfolge übereinander angeordnet- mindestens

- eine dimensionsstabile Trägerfolie (A) mit einer Dicke von 50 $\mu$m bis 300 $\mu$m,
- eine in organischen Lösemitteln lösliche oder dispergierbare, fotopolymerisierbare, reliefbildende Schicht (B) einer Schichtdicke von 300 $\mu$m bis 7000 $\mu$m, umfassend mindestens ein elastomeres Bindemittel, ein ethylenisch ungesättigtes Monomer sowie einen Fotoinitiator oder ein Fotoinitiatorsystem, sowie
- eine abziehbare Deckfolie (E),

wobei es sich bei der Trägerfolie um eine PET-Folie handelt, deren Schrumpf in Längsrichtung (MD-Schrumpf) und in Querrichtung (TD-Schrumpf) - bestimmt durch 15-minütiges Tempern der Folie bei 100°C- jeweils weniger als 0,02 % beträgt.

In einer bevorzugten Ausführungsform umfasst das fotopolymerisierbare Flexodruckelement zwischen der fotopolymerisierbaren Schicht (B) und der Deckfolie (E) eine laserablatierbare Maskenschicht (D).

Erfindungsgemäß wurde ein Verfahren zur Herstellung derartiger Flexodruckelemente gefunden, wobei man die Trägerfolie (A) bei einer Temperatur < 60°C mit der fotopolymerisierbaren Schicht (B) verbindet.

Weiterhin wurde die Verwendung der genannten Flexodruckelementen zur Herstellung von Flexodruckplatten durch Auswaschen mit organischen Lösemitteln gefunden, wobei man die ausgewaschenen Flexodruckplatten bei einer Temperatur von 60°C bis 120°C, bevorzugt 70°C bis 110°C trocknet.

Überraschenderweise wurde gefunden, dass derartige Flexodruckelemente nach dem Belichten in organischen Auswaschmitteln ausgewaschen werden und bei Temperaturen von mehr als 60°C getrocknet werden können und dennoch eine exzellente Registergenauigkeit aufweisen.

Zu der Erfindung ist im Einzelnen das Folgende auszuführen:
Im Folgenden werden die Begriffe "Flexodruckplatte", "Flexodruckform" oder "Klischee" für eine bereits vernetzte, druckfertige Druckform verwendet. Der Begriff "Flexodruckelement" wird in üblicher Art und Weise für das fotopolymerisierbare Ausgangsmaterial verwendet, welches zur Herstellung von Flexodruckformen bzw. Flexodruckplatten eingesetzt wird.

Trägerfolie (A)

Das Flexodruckelement umfasst als Träger eine Polyethylenterephthalat-Folie mit einer Dicke von 50 μm bis 300 μm, bevorzugt 75 μm bis 250 μm und besonders bevorzugt 100 μm bis 250 μm.

Hierbei handelt es sich um eine "schrumpflose" Folie. Der Schrumpf von Folien wird in üblicher Art und Weise durch Erwärmen der Folien auf eine bestimmte Temperatur und Messen der Foliendimensionen vor und nach dem Tempern gemessen. Aus den Messwerten wird der Schrumpf gemäß folgender Formel bestimmt:

$$\%Schrumpf = \frac{(Anfangsl\ddot{a}nge - Endl\ddot{a}nge)}{Anfangsl\ddot{a}nge} * 100$$

Aufgrund der Herstellung von Folien können die Werte für die Messung in Längsrichtung der Folienbahn (auch "machine direction", abgekürzt MD) und quer zur Folienbahn (auch "transversal direction", abgekürzt TD) unterschiedlich sein. Daher wird für die Folie der Schrumpf jeweils in Längsrichtung (MD) und in Querrichtung (TD) zur Folienbahn gemessen. Eine detaillierte Messprozedur ist im experimentellen Teil enthalten.

Erfindungsgemäß wird als Träger für das Flexodruckelement eine PET-Folie eingesetzt, welche einen Schrumpf in Längsrichtung (MD-Schrumpf) und einen Schrumpf in Querrichtung (TD-Schrumpf) von weniger als 0,02 % aufweist, wobei der Schrumpf durch 15-minütiges Tempern der Folie bei 100°C bestimmt wird.

Die erfindungsgemäß verwendeten PET-Trägerfolien sollten bevorzugt zumindest eine gewisse UV-Transparenz aufweisen, um eine Rückseitenvorbelichtung des Flexodruckelements zu ermöglichen. Bevorzugt weisen die PET-Trägerfolien eine UV-Transmission, gemessen bei 365 nm, von mindestens 5 %, bevorzugt mindestens 10 %, beispielsweise mindestens 50 % auf.

Die Trägerfolien können optional mit üblichen, haftvermittelnden Schichten behandelt sein. Sie können weiterhin mit UV-absorbierenden Schichten beschichtet sein, um zu hohe UV-Transmission zu verringern.

Die genannten Folien sind kommerziell erhältlich.

Reliefbildende Schicht (B)

Das Flexodruckelement umfasst weiterhin mindestens eine in organischen Lösemitteln, insbesondere Kohlenwasserstoffen lösliche oder dispergierbare, fotopolymerisierbare, reliefbildende Schicht (B) einer Schichtdicke von 300 μm bis 7000 μm, umfassend mindestens ein elastomeres Bindemittel, ein ethylenisch ungesättigtes Monomer sowie einen Fotoinitiator oder ein Fotoinitiatorsystem. Neben den genannten Komponenten können optional noch weitere Komponenten, wie beispielsweise Weichmacher, vorhanden sein.

Bei den elastomeren Bindemitteln kann es sich beispielsweise um thermoplastischelastomere Blockcopolymere, beispielsweise Styrol-Butadien- oder Styrol-Isopren-Blockcopolymere handeln. In organischen Lösemitteln lösliche oder zumindest dispergierbare Zusammensetzungen für reliefbildende Schichten sind dem Fachmann prinzipiell bekannt, und er wählt je nach den gewünschten Eigenschaften der Flexodruckplatte eine geeignete Zusammensetzung.

Selbstverständlich kann das Flexodruckelement auch mehrere in organischen Lösemitteln lösliche oder dispergierbare, fotopolymerisierbare, reliefbildende Schichten übereinander umfassen. Flexodruckelemente mit mehrschichtigem Aufbau der fotopolymerisierbaren, reliefbildenden Schicht sind dem Fachmann ebenfalls bekannt.

Die fotopolymerisierbare, reliefbildende Schicht weist eine Dicke von mindestens 300 μm, insbesondere 300 μm bis 7000 μm auf. Bevorzugt ist eine Dicke von 1000 μm bis 7000 μm, beispielsweise 2000 μm bis 7000 μm. In einer weiteren Ausführungsform der Erfindung beträgt die Dicke 3100 μm bis 7000 μm.

Laserablatierbare Maskenschicht (D)

Das Flexodruckelement kann weiterhin optional eine laserablatierbare Schicht umfassen.

Die laserablatierbare, in organischen Bindemitteln lösliche oder dispergierbare Maskenschicht (D), auch LAMS-Schicht genannt, umfasst mindestens ein elastisches Bindemittel, insbesondere weichelastische Bindemittel. Selbstverständlich können auch Gemische mehrerer verschiedener Bindemittel eingesetzt werden.

Die elastischen Bindemittel verleihen der laserablatierbaren Maskenschicht (D) eine ausreichende Flexibilität und Dehnung, so dass die Schicht beim Montieren auf die Trommel einer Laserapparatur nicht reißt oder runzelt. Außerdem sollte eine gute Haftung zu darunterliegenden Schichten gewährleistet sein.

Beispiele geeigneter Bindemittel umfassen weichelastische Polyamide. Derartige Polyamide umfassen als monomere Bausteine langkettige, bifunktionelle Fettsäuren, die dem Polyamid weichelastische Eigenschaften verleihen. Weiterhin können Polyesteramide, Cellulosederivate, Nitrocellulose, Ethylenvinylacetatcopolymere, Polyacrylate oder Mischungen der genannten Polymere eingesetzt werden, sofern sie weichelastische Eigenschaften besitzen.

In einer bevorzugten Ausführungsform des erfindungsgemäßen Herstellungsverfahrens handelt es sich um Bindemittel, die in organischen Lösemitteln, insbesondere organischen Lösemitteln mittlerer Polarität löslich sind. Beispiele von Lösemitteln mittlerer Polarität umfassen insbesondere mono- oder mehrfunktionelle Alkohole mit $C_4$- bis $C_{12}$-Kohlenwasserstoffresten. Die Polarität der Lösemittel kann in prinzipiell bekannter Art und Weise durch den sogenannten Löslichkeitsparameter beschrieben werden (Löslichkeitsparameter nach Hansen, J. Appl. Polym. Sci, 5 (15),339 (1961)). Die genannten Alkohole haben Löslichkeitsparameter in einem Bereich von 9 bis 12 $(cal/cm^3)^{1/2}$. Bei Schichten mit derartigen Bindemitteln lassen sich die Reste der laserablatierbaren Maskenschicht nach Bebilderung und bildmäßiger Belichtung mit marktüblichen Flexoauswaschmitteln umfassend unpolare Kohlenwasserstoffe und mäßig polare Alkohole (z.B. nylosolv® von Flint Group) lösen bzw. wegwaschen. Als Bindemittel für die laserablatierbare Maskenschicht besonders gut geeignet ist Makromelt® 6900 (Henkel AG), ein weichelastisches Polyamid.

Die laserablatierbare Maskenschicht (D) umfasst weiterhin UV/VIS-Licht absorbierende Materialien, wobei die Schichtdicke und/oder die Menge der lichtabsorbierenden Materialien so bemessen werden, dass die optische Dichte der Schicht für UV/VIS-Strahlung 2 bis 4 beträgt. Die hohe optische Dichte gewährleistet, dass die von der Maske bedeckten Bereiche der reliefbildenden Schicht im Zuge der vollflächigen Belichtung nicht polymerisieren.

Als lichtabsorbierendes Material eignet sich insbesondere feinteiliger Ruß. Ruß absorbiert auch sehr gut im IR-Bereich und gewährleistet somit bei der Bebilderung mittels IR-Laser gleichzeitig auch eine schnelle Bebilderung. Selbstverständlich kann die laserablatierbare Maskenschicht aber auch andere UV- oder IR- Absorber auf Pigmentbasis oder lösliche Farbstoffe enthalten. Ruß ist üblicherweise in einer Menge von 10 bis 50 Gew.-% bezüglich der Summe aller Komponenten enthalten.

Die Schichtdicke der Maskenschicht sollte einige wenige $\mu$m, bevorzugt 1 $\mu$m bis 4 $\mu$m betragen. Bei Schichtdicken unter 1 $\mu$m ist es schwierig, eine ausreichende optische Dichte zu erreichen. Bei Schichtdicken oberhalb von 3 $\mu$m ist die Laserempfindlichkeit des Elementes zu gering, so dass lange Laserzeiten zur Bebilderung notwendig sind.

Die Laserempfindlichkeit der Maskenschicht (gemessen als die Energie, die notwendig ist, um 1 $m^2$ Schicht zu ablatieren) sollte zwischen 1 und 4 $J/m^2$ liegen.

Deckfolie (D)

Die abziehbare Deckfolie (D) ist die oberste Schicht des Flexodruckelements und dient unter anderem dem Schutz des Flexodruckelemements. Die Deckfolie wird vor der Verwendung des Flexodrucklelements zur Herstellung von Flexodruckplatten abgezogen. Als abziehbare Deckfolien (E) eignen sich insbesondere PET-Folien mit mäßiger oder geringer Rauigkeit. Die Rz-Werte können beispielsweise 1 $\mu$m bis 3 $\mu$m betragen. Beispielsweise kann eine Mylar® A PET-Folie eingesetzt werden.

Aufbau des Flexodruckelements

In dem erfindungsgemäß hergestellten Flexodruckelement sind die Trägerfolie (A), die fotopolymerisierbare(n) Schicht(en) (B), sofern vorhanden die laserablatierbare Maskenschicht (D) sowie die Deckfolie (E) in dieser Reihenfolge direkt oder indirekt übereinander angeordnet.

Darüber hinaus kann das Flexodruckelement noch weitere Schichten umfassen: Beispielsweise kann das Flexodruckelement eine unterhalb der fotopolymerisierbaren Schicht angebrachte elastische Unterschicht ausweisen. Weiterhin kann die Trägerfolie (A) beispielsweise mit einer Haftschicht beschichtet sein, welche für eine bessere Haftung zwischen der Trägerfolie (A) und der fotopolymerisierbaren Schicht (B) oder einer elastischen Unterschicht sorgt.

Zwischen der fotopolymerisierbaren Schicht (B) und der laserablatierbaren Schicht (D) kann eine für UVA-Licht transparente Barriereschicht für Sauerstoff (C) angeordnet sein. Eine derartige Schicht limitiert oder verhindert während des Belichtens die Diffusion von Sauerstoff in die fotopolymerisierbare Schicht und trägt somit zu einem besseren Druckbild bei. Die Barriereschicht kann in prinzipiell bekannter Art und Weise ein polymeres Bindemittel mit einer niedrigen Durchlässigkeit für Sauerstoff umfassen. Beispiele geeigneter Bindemittel umfassen Polyamide, Polyvinylalkohol, Hydroxyalkylcellulose, Polyvinylpyrrolidon, Ethylen-Vinylacetat-Copolymere, amphotere Interpolymere, Celluloseacetatbutyrat, Alkylcellulose, Butyral, cyclische Kautschuke oder Kombinationen davon. Eine Barriereschicht weist üblicherweise eine Schichtdicke von 0.3 $\mu$m bis 5 $\mu$m auf. Weitere Einzelheiten zu Barriereschichten sind beispielsweise in US 5,262,275 oder WO 2012/145111 A1 offenbart.

Das Flexodruckelement kann weiterhin eine entklebende Schicht zwischen der Deckfolie (E) und der laserablatierbaren Schicht (D) umfassen, welche das Abziehen der Deckfolie vor dem Gebrauch erleichtern soll. Als Bindemittel für eine Entklebeschicht können beispielsweise die für eine laserablatierbare Schicht verwendeten Bindemittel verwendet werden.

Herstellung des Flexodruckelements

Die Herstellung des Flexodruckelements erfolgt erfindungsgemäß, indem man die Trägerfolie (A) bei einer Temperatur < 60°C mit der fotopolymerisierbaren Schicht (B) verbindet.

Beispielsweise können die Komponenten der fotopolymerisierbaren Schicht in einem geeigneten Lösemittel bzw. Lösemittelgemisch gelöst und bei T < 60°C auf die Trägerfolie aufgegossen werden.

Bevorzugt werden aber Verfahren verwendet, bei denen man eine vorgefertigte, feste fotopolymerisierbare Schicht (B) bei T < 60°C mittels eines Laminierprozesses mit der Trägerfolie (A) verbindet.

Die Herstellung der besagten fotopolymerisierbaren Flexodruckelemente kann mittels verschiedener Verfahren erfolgen.

In einer ersten Ausführungsform der Erfindung umfasst das Verfahren zumindest die Verfahrensschritte (1.1) bis (1.7).

Bei dieser Ausführungsform wird in einem ersten Schritt (1.1) ein Deckelement bereitgestellt, welche mindestens die Deckfolie (E) umfasst. Die Deckfolie kann mit weiteren Schichten beschichtet werden, so dass ein mehrschichtiges Deckelement erhalten wird. Die Deckfolie (E) kann optional mit einer entklebenden Schicht beschichtet werden, danach optional mit einer laserablatierbaren Schicht (D) sowie optional einer Barriereschicht (C). Die Schichten können aufgebracht werden, indem man die Komponenten löst, nacheinander auf die Deckfolie aufgießt und trocknet.

In einem zweiten Schritt (1.2) werden anschließend die Komponenten der fotopolymerisierbaren Schicht in prinzipiell bekannter Art und Weise in einem geeigneten Mischaggregat aufgeschmolzen, beispielsweise in einem Extruder, wobei die Temperatur der Schmelze typischerweise 120°C bis 170°C beträgt.

In einem dritten Verfahrensschritt (1.3) wird die Schmelze in ebenfalls prinzipiell bekannter Art und Weise durch eine Breitschlitzdüse in den Spalt eines Zweiwalzenkalanders eingefahren. Die Schmelze weist hierbei je nach Formulierung typischerweise Temperaturen von 120°C bis 170°C auf. Über eine der Walzen wird die beschichtete Deckfolie eingeführt. Über die andere Walze wird eine abziehbare, temporäre Trägerfolie eingefahren. Als temporäre Folie können beispielsweise siliconisierte PET-Folien oder mit einer Releaseschicht beschichtete PET-Folien eingesetzt werden.

In einem vierten Verfahrensschritt (1.4) wird der Verbund aus temporärer Trägerfolie, fotopolymerisierbarer Schicht sowie Deckelement (E) mittels der Kalanderwalzen kalandriert.

Nach Durchfahren des Kalanders wird der Verbund aus temporärer Trägerfolie, fotopolymerisierbarer Schicht sowie Deckelement in einem fünften Verfahrensschritt auf Temperaturen unter 60°C abgekühlt.

Bereits während oder nach der der Abkühlphase wird die temporäre Trägerfolie in einem sechsten Verfahrensschritt (1.6) von der fotopolymerisierbaren Schicht abgezogen.

Hat die Temperatur des Verbundes die Temperatur von 60°C unterschritten, wird die erfindungsgemäß zu verwendende Trägerfolie (A) in einem siebten Verfahrensschritt (1.7) haftfest mit der fotopolymerisierbaren Schicht (B) verbunden.

Das Verbinden kann mittels eines zweiten Kalanders oder einer Vorrichtung zum Laminieren erfolgen. Um die Trägerfolie haftfest mit der fotopolymeren Schicht zu verbinden, kann es vorteilhaft sein, die Trägerfolie mit einem Primer zu versehen und/oder den Verbund durch die Trägerfolie hindurch kurz mit UV-Licht zu belichten. Die Intensität und/oder die Dauer der Belichtung wird dabei soweit beschränkt, dass zwar die Haftung verbessert wird, nicht aber wesentliche Teile der fotopolymerisierbaren Schicht polymerisiert werden.

In einer zweiten Ausführungsform kann die Herstellung erfolgen, indem man in einem ersten Verfahrensschritt (2.1) zunächst einmal ein Deckelement bereitstellt, welches mindestens die Deckfolie (E) umfasst. Einzelheiten wurden bereits oben unter Schritt (1.1) beschrieben.

In einem zweiten Schritt (2.2) werden anschließend die Komponenten der fotopolymerisierbaren Schicht in prinzipiell bekannter Art und Weise in einem geeigneten Mischaggregat aufgeschmolzen, beispielsweise in einem Extruder, wobei die Temperatur der Schmelze typischerweise 120°C bis 170°C beträgt.

In einem dritten Verfahrensschritt (2.3) wird das oben beschriebene Deckelement mit der fotopolymerisierbaren Schmelze beschichtet. Hierzu wird eine Breitschlitzdüse verwendet, die über die gesamte Auftragsbreite konstante Schichtdicken liefert. Entsprechende Düsen und Techniken zur Einstellung der Dickenkonstanz sind dem Fachmann bekannt. Prinzipiell können mittels dieser Technik auch fotopolymerisierbare Schichten durch zwei hintereinander liegende Düsen aufgebracht werden, beispielsweise eine erste fotopolymerisierbare Schicht und eine dünne Oberschicht (Toplayer). Es erfolgt in diesem Stadium kein Kalandrierschritt.

In einem vierten Verfahrensschritt (2.4) wird der Verbund aus beschichteter Deckfolie und fotopolymerisierbarer Schicht zunächst auf eine Temperatur von weniger als 60°C abkühlen lassen.

Nach dem Unterschreiten einer Temperatur von 60°C wird in einem fünften Verfahrensschritt (2.5) die Trägerfolie (A) auf die fotopolymerisierbare Schicht auflaminiert. Das Verbinden kann mittels eines Kalanders oder einer anderen Vorrichtung zum Laminieren erfolgen. Eine gute Haftung zwischen der Trägerfolie und der fotopolymerisierbaren Schicht kann optional durch Beschichten der Trägerfolie mit einem Primer und/oderdurch kurzes Anbelichten der fotopolymerisierbaren Schicht mit UV-Licht durch die Trägerfolie hindurch erfolgen.

In einer dritten Ausführungsform kann die Herstellung erfolgen, indem man in einem ersten Verfahrensschritt (3.1) zunächst einmal ein Deckelement bereitstellt, welches mindestens die Deckfolie (E) umfasst. Einzelheiten wurden bereits oben unter Schritt (1.1) beschrieben.

In einem zweiten Schritt (3.2) werden anschließend die Komponenten der fotopolymerisierbaren Schicht in prinzipiell bekannter Art und Weise in einem geeigneten Mischaggregat aufgeschmolzen, beispielsweise in einem Extruder, wobei die Temperatur der Schmelze typischerweise 120°C bis 170°C beträgt.

In einem dritten Verfahrensschritt (3.3) wird das oben beschriebene Deckelement mit der fotopolymerisierbaren Schmelze beschichtet. Einzelheiten zu diesem Prozess wurden bereits beschrieben.

Der Verbund aus beschichteter Deckfolie und fotopolymerisierbarer Schicht wird in einem Verfahrensschritt (3.4) vollständig abgekühlt und kann anschließend aufgewickelt werden.

In einem fünften Verfahrensschritt (3.5) kann der erhaltene Wickel abgewickelt werden, und kann dann anschließend in einer Laminiermaschine oder Kalandereinheit bei Temperaturen < 60°C mit der Trägerfolie (A) verbunden werden.

Das erfindungsgemäße Verfahren, bei dem man die fotopolymerisierbare Schicht (B) bei T < 60°C mit der Trägerfolie (A) verbindet, hat den Vorteil, dass die schrumpfarme Trägerfolie (A) nicht durch Erhitzen auf höhere Temperaturen beeinträchtigt wird. Die fotopolymerisierbare Schmelze weist üblicherweise eine Temperatur von ca. 120 °C bis 170 °C auf, und die dünne Trägerfolie heizt sich beim Kontakt mit der Schmelze auch schnell auf diese Temperatur auf. Beim erfindungsgemäßen Herstellverfahren bleibt die Temperaturbelastung der Folie unterhalb 60°C und es werden Flexodruckelemente mit einer besonders guten Maßhaltigkeit erhalten.

Beschrieben hierhin wird auch ein Flexodruckelement umfassend

- eine dimensionsstabile Trägerfolie (A) mit einer Dicke von 50 $\mu$m bis 300 $\mu$m,
- eine in organischen Lösemitteln lösliche oder dispergierbare, fotopolymerisierbare, reliefbildende Schicht (B) einer Schichtdicke von 300 $\mu$m bis 7000 $\mu$m, umfassend mindestens ein elastomeres Bindemittel, ein ethylenisch ungesättigtes Monomer sowie einen Fotoinitiator oder ein Fotoinitiatorsystem,
- optional eine Barriereschicht für Sauerstoff (C),
- optional eine laserablatierbare Maskenschicht (D), sowie
- eine abziehbare Deckfolie €,

wobei es sich bei der Trägerfolie um eine PET-Folie handelt, deren Schrumpf in Längsrichtung (MD-Schrumpf) und in Querrichtung (TD-Schrumpf) -bestimmt durch 15-minütiges Tempern der Folie bei 100°C- jeweils weniger als 0,02 % beträgt, und wobei das Flexodruckelement durch ein Verfahren erhältlich ist, bei dem man die Trägerfolie (A) bei einer Temperatur < 60°C mit der fotopolymerisierbaren Schicht (B) verbindet.

## Verwendung der Flexodruckelemente zur Herstellung von Flexodruckplatten

Die Flexodruckelemente werden erfindungsgemäß zur Herstellung von Flexodruckplatten verwendet. Die Art und Weise der Verarbeitung richtet sich hierbei nach der Art des verwendeten Flexodruckelements.

In einer Ausführungsform handelt es sich um ein digital bebilderbares Flexodruckelement, welches neben der Trägerfolie (A), der fotopolymerisierbaren Schicht (B) sowie der Deckfolie (E) mindestens noch eine laserablatierbare Maskenschicht (D) umfasst. Das digital bebilderbare Flexodruckelement kann darüber hinaus auch noch eine Barriereschicht für Sauerstoff (C) umfassen.

Zunächst wird in prinzipiell bekannter Art und Weise die Deckfolie (D) vom Flexodruckelement entfernt. Anschließend wird in prinzipiell bekannter Art und Weise eine Maske in die laserablatierbare Maskenschicht (C) mithilfe eines IR-Lasers eingeschrieben. Laserapparaturen zum Einschreiben von Masken sind dem Fachmann bekannt und sind kommerziell erhältlich. Prinzipiell können alle marktüblichen Laser (überwiegend Außentrommellaser) verwendet werden. Anschließend wird das bebilderte Flexodruckelement mit UV- bzw. UV-VIS-Strahlung durch die gebildete Maske hindurch in prinzipiell bekannter Art und Weise belichtet. Hierbei polymerisiert die fotopolymerisierbare Schicht in den von der Maske nicht mehr abgedeckten Bereichen, während in den abgedeckten Bereichen keine Polymerisation erfolgt. Apparaturen zum Belichten von Flexodruckplatten sind dem Fachmann prinzipiell bekannt. Die Belichtung der Flexodruckelemente kann mit marktüblichen Röhrenbelichtern oder UV-LED Hochenergieleisten erfolgen.

Vor der Hauptbelichtung durch die Maske hindurch kann optional eine Rückseitenvorbelichtung durch die Trägerfolie (A) erfolgen. Durch die Rückseitenvorbelichtung wird der Untergrund der fotopolymerisierbaren Schicht vollständig polymerisiert. Der Untergrund bietet den Reliefelementen guten Halt, so dass die Reliefelemente während des Druckens nicht beschädigt werden. Je dicker die Flexodruckplatte, desto dicker der Untergrund. Dies kann durch Belichtungsdauer und -intensität gesteuert werden. Typische Rückbelichtungszeiten betragen mit üblichen Belichtern beispielsweise ca. 20 bis 120 s, ohne dass die Erfindung damit auf diesen Bereich beschränkt sein soll.

Die erfindungsgemäß verwendete Trägerfolie (A) aus PET hat den Vorteil, dass sie zumindest eine gewisse UV-Durchlässigkeit aufweist. PEN-Folien haben eine hohe UV-Absorption und sperren unterhalb von ca. 380 nm UV-Licht nahezu vollkommen und erschweren somit zumindest den Vorgang der Rückseitenvorbelichtung.

Nach dem Belichten werden die Reste der laserablatierbaren Maskenschicht (D) sowie die nicht polymerisierten Anteile der reliefbildenden Schicht (B) unter Verwendung eines organischen Auswaschmittels entfernt. Sofern vorhanden, kann eine Barriereschicht (C) auch mit dem Auswaschschritt entfernt werden. Dies kann unter Verwendung üblicher Auswaschgeräte, insbesondere unter Verwendung von Flachbett-Auswaschgeräten, erfolgen.

In einer Ausführungsform der Erfindung weist das digital bebilderbare Flexodruckelement keine vorgefertigte Barriereschicht (C) auf, sondern nach dem Einschreiben einer Maske in die laserablatierbare Schicht (D) wird eine dünne, UVdurchlässige Schutzfolie, beispielsweise eine dünne PET-Folie auflaminiert, welche die fotopolymerisierbare Schicht während des Belichtens vor Sauerstoff schützt. Nach dem Belichten wird die Folie wieder abgezogen und das Flexodruckelement kann wie beschrieben ausgewaschen werden.

In einer bevorzugten Ausführungsform der Erfindung enthält das verwendete Auswaschmittel Kohlenwasserstoffe. Bei den Kohlenwasserstoffen kann es sich insbesondere um hochsiedende aliphatische, cycloaliphatische oder aromatische Kohlenwasserstofffraktionen, insbesondere solche mit einem Siedebereich von 160 bis 220°C handeln. In einer bevorzugten Ausführungsform der Erfindung umfasst das Auswaschmittel 60 Gew. % bis 95 Gew. % Kohlenwasserstoffe sowie 5 Gew. % bis 40 Gew. % Alkohole. Es versteht sich von selbst, dass es sich bei den Alkoholen um solche handelt, die mit den Kohlenwasserstoffen mischbar sind. Es werden in der Regel Monoalkohole mit mindestens 4 Kohlenstoffatomen, bevorzugt mindestens 5 Kohlenstoffatomen, beispielsweise 5 bis 10 Kohlenstoffatomen eingesetzt. Beispiele umfassen n-Pentanol, Cyclohexanol, Benzylalkohol, Heptylalkohole oder 2-Ethylhexanol.

Die erhaltene Flexodruckplatte wird erfindungsgemäß anschließend bei einer Temperatur von mehr als 60°C bis 120°C, insbesondere 70°C bis 120°C getrocknet. Bevorzugt beträgt die Trocknungstemperatur 70°C bis 110°C, besonders bevorzugt 80°C bis 100°C und beispielsweise 90°C bis 100°C. Der Trocknungsschritt kann beispielsweise in Schubladentrocknern erfolgen.

Schließlich kann die erhaltene Flexodruckplatte in prinzipiell bekannter Art und Weise mit UV-A und/oder UV-C-Licht nachbehandelt werden.

Das Verfahren zur Herstellung von Flexodruckformen kann selbstverständlich noch weitere Verfahrensschritte umfassen. Beispielsweise ist auch eine mehrstufige Entwicklung unter Verwendung unterschiedlicher Lösemittel bzw. Lösemittelmischungen denkbar.

Die erfindungsgemäß hergestellten Flexodruckelemente haben den Vorteil, dass sie auch bei höheren Temperaturen, insbesondere 90°C bis 100°C getrocknet werden können, ohne dass die Maßhaltigkeit der Flexodruckplatte beeinträchtigt wird. Die Trockenzeit nimmt durch die höhere Temperatur deutlich ab.

In einer weiteren Ausführungsform werden Flexodruckelemente eingesetzt, welche keine laserablatierbare Maskenschicht aufweisen. Nach dem Abziehen der Deckfolie (E) wird eine Maske auf die fotopolymerisierbare Schicht (B) aufgelegt oder auflaminiert und das Flexodruckelement wird durch die Maske hindurch belichtet. Bei der Maske kann es sich beispielsweise um eine konventionelle fotographische Maske handeln. Bevorzugt handelt es sich um eine digital bebilderbare Maske, welche zunächst mit einer Laserapparatur bebildert wird. Anschließend wird die bebilderte Maske auf die fotopolymerisierbare Schicht (B) aufgelegt oder bevorzugt auflaminiert. Dach dem Belichten kann die Maske -je nach Art der Maske- von der bildmäßig belichteten Schicht abgezogen werden oder aber auch mit dem Auswaschmittel entfernt werden.

Bei der genannten Ausführungsform kann die fotopolymerisierbare Schicht (B) optional mit einer Entklebeschicht beschichtet sein. Die Entklebeschicht erleichtert das Abziehen der Deckfolie (E) und verhindert, dass eine aufgelegte Maske nicht auf der fotopolymerisierbaren Schicht festklebt, sondern wieder abgezogen werden kann.

Die folgenden Beispiele sollen die Erfindung erläutern.

Beispiele

Verwendete Trägerfolien

Vorschrift zur Bestimmung des Schrumpfs der Folien:

Aus der Mitte einer Folie wird ein 25 cm x 25 cm großes Stück zugeschnitten. Danach wird die Probe mit einem A4 Locher im Abstand von 20 cm auf der Längssowie auf der Querseite gelocht. Mit einem Meßlineal (Fa. Messerli) werden dann die Abstände der Stanzlöcher von Innenkante zu Innenkante gemessen. Anschließend wird die Probe 15 Minuten bei der angegebenen Temperatur im Umluft-Trockenschrank getempert. Nach dem Abkühlen werden wiederum die Abstände gemessen und der Schrumpfwert berechnet.

$$\%Schrumpf = \frac{(Anfangslänge - Endlänge)}{Anfangslänge} * 100$$

Es werden sowohl der Schrumpf in Längsrichtung der Folienbahn (auch "machine direction", abgekürzt MD) sowie quer zur Folienbahn (auch "transversal direction", abgekürzt TD) bestimmt. Der MD-Schrumpf und der TD-Schrumpf können jeweils unterschiedliche Werte aufweisen.

Es wurden die in der nachfolgenden Tabelle 1 angegebenen PET-Folien eingesetzt. Bei der einen handelt es sich um eine erfindungsgemäß zu verwendende, "schrumpflose" Folie und bei der anderen um eine zu Vergleichszwecken verwendete Standard PET-Folie. Es wurde jeweils der Schrumpf und außerdem die Transmission für UV-Strahlung gemessen.

Zum Vergleich sind außerdem zwei PEN-Folien (Teonex® Q83 und Teonex® Q51, beide von DuPont Teijin Films) in Tabelle angegeben. Die UV-Transmission der beiden PEN-Folien ist trotz geringerer Schichtdicke schon so hoch, dass eine Rückseitenbelichtung des Flexodruckelements durch die Trägerfolie hindurch praktisch nicht möglich ist. Damit können die Flexodruckelemente aber nicht mehr zu Flexodruckplatten hoher Qualität verarbeitet werden.

Tabelle 1: Verwendete Folien (*Hersteller: Dupont-Teijin)

| | Material | Name | Dicke [μm] | UV-Transmission [%] bei 365 nm | MD 60°C | MD 100°C | MD 150°C | TD 60°C | TD 100°C | TD 150°C |
|---|---|---|---|---|---|---|---|---|---|---|
| "Schrumpflose" Folie | PET | Melinex® ST 506* | 175 | 76,9% | - | 0,01 | 0,01 | - | 0,02 | 0,04 |
| Standard | PET | Standard PET-Folie | 175 | | 0,06 | 0,52 | - | 0,04 | 0,214 | - |
| | PEN | Teonex® Q83* | 125 | 0,09% | | | | | | |
| | PEN | Teonex® Q51*, | 125 | 0,06% | | | | | | |

A) Erfindungsgemäße Herstellung der Flexodruckelemente

Es wurden laserablatierbare, photopolymerisierbare Flexodruckelemente vom Typ nyloflex® ACE 114 D (Gesamtdicke 1.14 mm) im Format 900 x1200 mm auf konventionelle Art und Weise produziert: Die Bestandteile der photopolymerisierbaren Schicht wurden in einem Extruder aufgeschmolzen und vermischt und die Schmelze wurde mit einer Temperatur von 145 °C durch eine Breitschlitzdüse in einen Kalanderspalt ausgetragen. Über die eine Kalanderwalze wurde in üblicher Art und Weise ein Deckelement umfassend eine Schutzfolie und eine darauf aufgebrachte laserablatierbare Schicht geführt. Über die andere Kalanderwalze wurde an Stelle der üblichen Trägerfolie eine mit einer Entklebungsschicht versehene PET Folie als temporäre Folie eingefahren. Die Kalanderwalzen hatten eine Temperatur von 85 °C und der Verbund aus Deckelement, photopolymerisierbarer Schicht und temporärer Trägerfolie wurde zwischen den Kalanderwalzen kalandriert und anschließend abgekühlt.

Zur Herstellung des Flexodruckelements wurde die temporäre PET Folie zusammen mit der Entklebungsschicht abgezogen. Die Flexodruckelemente wurden auf 50°C vorgewärmt und mit einer "schrumpflosen" geprimerten PET Trägerfolie mit einer Dicke von 175 $\mu$m (Melinex® ST 506, Dupont-Teijin) in einem Laminator ohne Aufwendung von Zugkräften haftfest verbunden. Die Schrumpfwerte und die UV-Durchlässigkeit der Folie sind in Tabelle 1 angegeben.

B) Verarbeitung der fotopolymerisierbaren Flexodruckelemente zu Flexodruckplatten

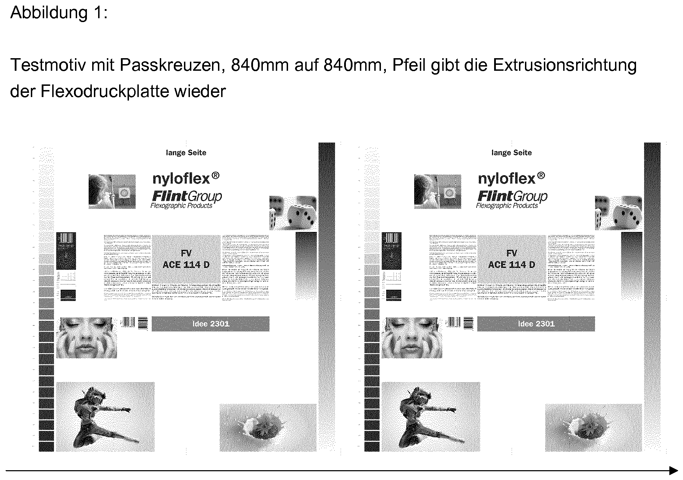

Von den fotopolymerisierbaren Flexodruckelementen wurde zunächst die Deckfolie abgezogen und danach wurde unter Verwendung einer handelsüblichen Vorrichtung zum Laserablatieren (Esko CDI Spark 5080) ein Motiv (840 mm x 840 mm, siehe Abbildung 1) in die laserablatierbare Schicht eingeschrieben.

Auf dem Motiv waren auf jeder Seite Passkreuze angebracht. Der Abstand zwischen den Passkreuzen sollte laut verwendetem Datenfile exakt 820 mm betragen. Der Abstand wurde nun durch eine Messung überprüft. Gemessen wurde jeweils der Abstand zwischen den Passkreuzen auf jeder der vier Seiten des Motivs. Der Pfeil in Abbildung 1 zeigt die Richtung an, in der die Platten ursprünglich extrudiert wurden. Die Messungen wurden mit einem Glaslineal mit mikroskopischer Erfassung der Messkreuze (electronic scale, Firma M-Service) durchgeführt.

Jede Messung wurde fünfmal wiederholt und ein Mittelwert errechnet.

Die gelaserten Flexodruckelemente wurden anschließend auf üblicher Art und Weise zu einer Flexodruckplatte verarbeitet, und zwar mittels folgender Schritte:

- UVA Rückseitenbelichtung 9 Sekunden (nyloflex® Combi F III von Flint Group)
- UVA Hauptbelichtung 15 Minuten (nyloflex® Combi FIII von Flint Group)
- Auswaschgeschwindigkeit 270 mm/min (nyloflex® FV Durchlaufwascher von Flint Group)
- Auswaschmittel nyloflex® E (Flint Group) bei einer Auswaschtemperatur von 35°C

Die ausgewaschenen Flexodruckplatten wurden anschließend in einem nyloflex® Combi F III Schubladentrockner bei unterschiedlichen Temperaturen unterschiedlich lange getrocknet, und zwar:

|  |  |
|---|---|
| Beispiel 1: | 120 Minuten bei 60°C |
| Beispiel 2: | 40 Minuten bei 80°C |
| Beispiel 3: | 20 Minuten bei 100°C |

Danach wurden die Flexodruckplatten aus dem Trockner geholt, auf Raumtemperatur abgekühlt und standardmäßig mit UVA- und UVC-Licht nachbehandelt. Anschließend wurde wiederum der Abstand der Messkreuze auf jeder Seite der Flexodruckplatte wie oben beschrieben gemessen und der Quotient aus der Differenz des Messwertes und der ursprünglichen Länge gebildet. Dieser Quotient (%) ist ein Maß dafür, wie sich die Maße des Klischees durch die unterschiedliche Verarbeitung verändert haben. Der geometrische Fehler der Messmethode liegt bei plus/minus 0.01%.

Als Vergleichsversuche wurde eine Standardplatte (nyloflex® ACE 114 D) mit üblicher Trägerfolie wie beschrieben verarbeitet und bei unterschiedlichen Temperaturen getrocknet. Die Schrumpfwerte der Folie sind in Tabelle 1 angegeben.

|  |  |
|---|---|
| Vergleichsbeispiel 1: | 120 Minuten 60°C |
| Vergleichsbeispiel 2: | 20 Minuten bei 100°C |

Die Ergebnisse sind in Tabelle 2 zusammengefasst:

In einem weiteren Vergleichsbeispiel 3 wurde ein fotopolymerisierbares Flexodruckelement mittels des üblichen, oben beschriebenen Verfahrens hergestellt, nur wurde anstelle der temporären PET-Folie die oben beschrieben, schrumpflose geprimerte PET-Trägerfolie (Melinex® ST 506, Dupont-Teijin) eingesetzt.

Dementsprechend wurde diese Folie im Zuge der Herstellung hohen Temperaturen durch die schmelzflüssige, fotopolymerisierbare Schicht ausgesetzt. Der Versuche musste abgebrochen werden, da sich die Folie so stark verzog, so dass sich Wellen auf dem Flexodruckelement bildeten.

Tabelle 2: Schrumpfung / Längung der getesteten Flexodruckplatten in Abhängigkeit von Folie und Trocknungsbedingungen. Positive Werte zeigen eine Längung des Klischees an, negative Werte eine Schrumpfung.

| Beispiel | PET-Folie | Trocknung | | Schrumpfung / Längung [%] | | | |
|---|---|---|---|---|---|---|---|
| | | Temperatur [°C] | Dauer [min] | Seite 1 (MD) | Seite 2 (TD) | Seite 3 (MD) | Seite 4 (TD) |
| 1 | schrumpflos | 60 | 120 | 0.008 | 0.006 | 0,003 | -0.004 |
| 2 | schrumpflos | 80 | 40 | 0.007 | 0.005 | 0.000 | 0.012 |
| 3 | schrumpflos | 100 | 20 | -0.009 | -0.004 | -0.012 | 0.009 |
| V1 | Standard | 60 | 120 | -0.012 | -0.014 | -0.013 | -0.005 |
| V2 | Standard | 100 | 20 | -0.254 | -0.007 | -0.255 | -0.043 |

Die Ergebnisse belegen, dass übliche Flexodruckplatten stark und unterschiedlich schrumpfen, wenn sie bei Temperaturen über der Glasstufe der Polyesterträgerfolie getrocknet werden (Vergleichsversuch 2). Ein solches Klischee ist für den hochqualitativen Flexodruck unbrauchbar. Die erfindungsgemäßen Klischees (Beispiele 1 bis 3) zeigen dagegen allesamt Schrumpf/Längungswerte an, die geringer als der Messfehler sind. Diese Klischees sind für den hochqualitativen Flexodruck geeignet.

Überraschenderweise sind die Messwerte an den erfindungsgemäß hergestellten Flexodruckklischees sogar geringer als beim Vergleichsversuch 1, bei dem eine Standardflexodruckplatte bei einer Standardtemperatur von 60°C getrocknet wurde.

Effekt der Folie auf die Rückseitenvorbelichtung:

Der Effekt der Folie auf die Rückseitenvorbelichtung wird mit den folgenden Experimenten gezeigt. Es wurden laserablatierbare, photopolymerisierbare Flexodruckelemente vom Typ nyloflex® ACE 170 D (Gesamtdicke 1.70 mm) nach der obigen Vorschrift hergestellt. Als Trägerfolie wurden zwei verschiedene 125 μm dicke PEN-Folien (Teonex® Q83 und Teonex® Q51, beide von DuPont Teijin Films) und zum Vergleich eine 125 μm dicke PET-Folie (Melinex® D 740, ebenfalls DuPont Teijin Films) verwendet. Wie üblich wurde mittels Rückseitenvorbelichtung die für diese Plattenstärke erforderliche Relieftiefe von 800 μm eingestellt, und es wurde die hierzu jeweils erforderliche Belichtungszeit ermittelt. Die Ergebnisse sind in der Tabelle 3 zusammengefasst.

Tabelle 3: Dauer der Rückseitenvorbelichtung bei verschiedenen Trägerfolien

| | Folienart | Rückseitenvorbel ichtungszeit |
|---|---|---|
| Teonex® Q51 | PET, 125 μm | > 1000 s |
| Teonex® Q83 | PEN, 125 μm | > 1000 s |
| Melinex® D 740 | PEN, 125 μm | 65 s |

Die Ergebnisse zeigen, dass nur bei Verwendung der PET-Folie eine übliche Dauer für die Rückseitenvorbelichtung erhalten wird. Bei Verwendung der PEN-Folien sind Belichtungszeiten erforderlich, welche in der Praxis nicht mehr akzeptabel sind.

**Patentansprüche**

1. Verfahren zur Herstellung eines fotopolymerisierbaren, unter Verwendung von Kohlenwasserstoffe umfassenden Auswaschmitteln entwickelbaren Flexodruckelements zur Herstellung von Flexodruckplatten, umfassend -in der genannten Reihenfolge übereinander angeordnet- mindestens

   • eine dimensionsstabile PET-Trägerfolie (A) mit einer Dicke von 50 $\mu$m bis 300 $\mu$m, deren Schrumpf in Längsrichtung (MD-Schrumpf) und in Querrichtung (TD-Schrumpf), bestimmt durch 15-minütiges Tempern der Folie bei 100°C, jeweils weniger als 0,02 % beträgt,
   • eine in organischen Lösemitteln lösliche oder dispergierbare, fotopolymerisierbare, reliefbildende Schicht (B) einer Schichtdicke von 300 $\mu$m bis 7000 $\mu$m, umfassend mindestens ein elastomeres Bindemittel, ein ethylenisch ungesättigtes Monomer sowie einen Fotoinitiator oder ein Fotoinitiatorsystem, sowie
   • eine Deckfolie (E),

   wobei das Verfahren mindestens die folgenden Schritte umfasst:

   (1.1) Bereitstellen eines Deckelements umfassend mindestens eine Deckfolie (E),
   (1.2) Aufschmelzen und Mischen der Komponenten der fotopolymerisierbaren, reliefbildenden Schicht in einem Mischaggregat bei einer Temperatur von 120°C bis 170°C,
   (1.3) Austragen der Schmelze durch eine Breitschlitzdüse in den Spalt eines Kalanders, wobei über eine Walze des Kalanders eine temporäre Trägerfolie und über die andere Walze des Kalanders das Deckelement eingefahren wird,
   (1.4) Kalandrieren des Verbunds aus temporärer Trägerfolie, fotopolymerisierbarer Schicht und Deckelement,
   (1.5) Abkühlen des Verbunds aus temporärer Trägerfolie, fotopolymerisierbarer Schicht und Deckelement auf eine Temperatur < 60°C,
   (1.6) Abziehen der temporären Trägerfolie von der fotopolymerisierbaren Schicht (B),
   (1.7) Verbinden des auf Temperaturen von weniger als 60°C abgekühlten Verbunds mit der Seite der fotopolymerisierbaren Schicht mit einer PET-Trägerfolie einer Dicke von 50 $\mu$m bis 300 $\mu$m, deren Schrumpf in Längsrichtung (MD-Schrumpf) und in Querrichtung (TD-Schrumpf), bestimmt durch 15-minütiges Tempern der Folie bei 100°C, jeweils weniger als 0,02 % beträgt.

2. Verfahren zur Herstellung eines Flexodruckelements nach Anspruch 1 **dadurch gekennzeichnet, dass** es sich bei der temporären PET-Folie um eine siliconisierte PET-Folie oder eine mit einer Releaseschicht beschichtete PET-Folie handelt.

3. Verfahren zur Herstellung eines Flexodruckelements nach Anspruch 1 oder 2, **dadurch gekennzeichnet, dass** man die Deckfolie (E) in einem vorausgehenden Arbeitsschritt mit einer laserablatierbaren Maskenschicht (D) beschichtet.

4. Verfahren zur Herstellung eines Flexodruckelements nach Anspruch 3, **dadurch gekennzeichnet, dass** man die mit einer laserablatierbaren Maskenschicht (D) beschichtete Deckfolie (E) weiterhin mit einer Barriereschicht für Sauerstoff beschichtet.

5. Verfahren zur Herstellung eines Flexodruckelements nach einem der Ansprüche 1 bis 4, **dadurch gekennzeichnet, dass** das Verbinden mittels eines Laminierverfahrens oder Kalandrierverfahrens erfolgt.

**Claims**

1. Methods of forming a photopolymerizable flexographic printing element for making flexographic printing plates which is developable by use of washout media comprising hydrocarbons and which comprises - arranged on top of each other in the stated order - at least

   • a dimensionally stable PET supporting sheet (A) having a thickness of 50 $\mu$m to 300 $\mu$m, whose shrinkage in the longitudinal direction (MD shrinkage) and in the transversal direction (TD shrinkage) as determined by annealing the sheet at 100°C for 15 minutes is in each case less than 0.02%,
   • a photopolymerizable, relief-forming layer (B) which is soluble or dispersible in organic solvents and has a layer thickness of 300 $\mu$m to 7000 $\mu$m, comprising at least an elastomeric binder, an ethylenically unsaturated monomer and a photoinitiator or photoinitiator system, and
• a coversheet (E),

wherein the method comprises at least the steps of

(1.1) providing a covering element comprising at least one coversheet (E),
(1.2) melting and mixing the components of the photopolymerizable, relief-forming layer in a mixing assembly at a temperature of 120°C to 170°C,
(1.3) exporting the melt through a sheet die into the nip of a calender while importing into said nip a temporary supporting sheet via one roll of the calender and the covering element via the other roll of the calender,
(1.4) calendering the composite of temporary supporting sheet, photopolymerizable layer and covering element,
(1.5) cooling the composite of temporary supporting sheet, photopolymerizable layer and covering element down to a temperature < 60°C,
(1.6) peeling the temporary supporting sheet off the photopolymerizable layer (B),
(1.7) bonding the composite, cooled down to temperatures of less than 60°C, with the side of the photopolymerizable layer to a PET supporting sheet having a thickness of 50 $\mu$m to 300 $\mu$m and whose shrinkage in the longitudinal direction (MD shrinkage) and in the transversal direction (TD shrinkage) as determined by annealing the sheet at 100°C for 15 minutes is in each case less than 0.02%.

2.  Method of forming a flexographic printing element according to Claim 1, **characterized in that** the temporary PET sheet comprises a siliconized PET sheet or a release-coated PET sheet.

3.  Method of forming a flexographic printing element according to Claim 1 or 2, **characterized in that** the coversheet (E) is coated with a laser-ablatable mask layer (D) in a preceding step.

4.  Method of forming a flexographic printing element according to Claim 3, **characterized in that** the coversheet (E), coated with a laser-ablatable mask layer (D) is further coated with an oxygen barrier layer.

5.  Method of forming a flexographic printing element according to any one of Claims 1 to 4, **characterized in that** the bonding step is effected using a lamination process or a calendering process.

## Revendications

1.  Procédé de fabrication d'un élément de flexographie photopolymérisable, pouvant être développé en utilisant des agents de lavage comprenant des hydrocarbures, pour la fabrication de plaques de flexographie, comprenant, agencés les uns sur les autres dans l'ordre indiqué, au moins :

- un film support en PET de dimensions stables (A) d'une épaisseur de 50 $\mu$m à 300 $\mu$m, dont le retrait dans la direction longitudinale (retrait MD) et dans la direction transversale (retrait TD), déterminé par recuit pendant 15 minutes du film à 100 °C, est à chaque fois inférieur à 0,02 %,
- une couche photopolymérisable formant un relief (B), soluble ou dispersible dans des solvants organiques, d'une épaisseur de couche de 300 $\mu$m à 7 000 $\mu$m, comprenant au moins un liant élastomère, un monomère éthyléniquement insaturé, ainsi qu'un photoinitiateur ou un système de photoinitiateurs, et
- un film de recouvrement (E),

le procédé comprenant au moins les étapes suivantes :

(1.1) la préparation d'un élément de recouvrement comprenant au moins un film de recouvrement (E),
(1.2) la fusion et le mélange des composants de la couche photopolymérisable formant un relief dans un appareil de mélange à une température de 120 ° à 170 °C,
(1.3) le déchargement de la masse fondue par une buse à fente large dans la fente d'une calandre, un film support temporaire étant introduit sur un cylindre de la calandre et l'élément de recouvrement sur l'autre cylindre de la calandre,
(1.4) le calandrage du composite constitué par le film support temporaire, la couche photopolymérisable et l'élément de recouvrement,
(1.5) le refroidissement du composite constitué par le film support temporaire, la couche photopolymérisable et l'élément de recouvrement à une température < 60 °C,

(1.6) le retrait du film support temporaire de la couche photopolymérisable (B),

(1.7) la liaison du composite refroidi à des températures inférieures à 60 °C avec le côté de la couche photopolymérisable avec un film support en PET d'une épaisseur de 50 $\mu$m à 300 $\mu$m, dont le retrait dans la direction longitudinale (retrait MD) et dans la direction transversale (retrait TD), déterminé par recuit pendant 15 minutes du film à 100 °C, est à chaque fois inférieur à 0,02 %.

2. Procédé de fabrication d'un élément de flexographie selon la revendication 1, **caractérisé en ce que** le film en PET temporaire est un film en PET siliconé ou un film en PET revêtu d'une couche anti-adhérente.

3. Procédé de fabrication d'un élément de flexographie selon la revendication 1 ou 2, **caractérisé en ce que** le film de recouvrement (E) est revêtu avec une couche de masquage (D) amovible par laser lors d'une étape précédente.

4. Procédé de fabrication d'un élément de flexographie selon la revendication 3, **caractérisé en ce que** le film de recouvrement (E) revêtu avec une couche de masquage (D) amovible par laser est en outre revêtu avec une couche de barrière pour l'oxygène.

5. Procédé de fabrication d'un élément de flexographie selon l'une quelconque des revendications 1 à 4, **caractérisé en ce que** la liaison a lieu au moyen d'un procédé de laminage ou d'un procédé de calandrage.

Abbildung 1:

Testmotiv mit Passkreuzen, 840mm auf 840mm, Pfeil gibt die Extrusionsrichtung der Flexodruckplatte wieder

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2005121898 A1
- WO 9614603 A1
- WO 9403838 A1
- US 5262275 A
- WO 2012145111 A1

**In der Beschreibung aufgeführte Nicht-Patentliteratur**

- **HANSEN.** *J. Appl. Polym. Sci,* 1961, vol. 5 (15), 339